# EUROPÄISCHE PATENTSCHRIFT

(11) **EP 4 237 884 B1**
(45) Veröffentlichungstag und Bekanntmachung des Hinweises auf die Patenterteilung: **27.08.2025**
(21) Anmeldenummer: 21789652.1
(22) Anmeldetag: 05.10.2021
(51) Int. Cl.: G02B 5/08, G21K 1/06, H05G 2/00, G03F 7/00

(54) **OPTISCHES ELEMENT, INSBESONDERE ZUR REFLEXION VON EUV-STRAHLUNG, OPTISCHE ANORDNUNG UND VERFAHREN ZUM HERSTELLEN EINES OPTISCHEN ELEMENTS**
OPTICAL ELEMENT, IN PARTICULAR FOR REFLECTING EUV RADIATION, OPTICAL ARRANGEMENT, AND METHOD FOR MANUFACTURING AN OPTICAL ELEMENT
ÉLÉMENT OPTIQUE, EN PARTICULIER POUR LA RÉFLEXION D'UN RAYONNEMENT ULTRAVIOLET EXTRÊME, ENSEMBLE OPTIQUE ET PROCÉDÉ DE FABRICATION D'UN ÉLÉMENT OPTIQUE

(30) Priorität: 29.10.2020 DE 102020213639
(43) Veröffentlichungstag der Anmeldung: 06.09.2023
(73) Patentinhaber: Carl Zeiss SMT GmbH, 73447 Oberkochen (DE)
(72) Erfinder: SHKLOVER, Vitaliy, 89522 Heidenheim (DE)
(74) Vertreter: Kohler Schmid Möbus Patentanwälte
(86) Internationale Anmeldenummer: PCT/EP2021/077360
(87) Internationale Veröffentlichungsnummer: WO 2022/089885

(56) Entgegenhaltungen:
- WO-A1-2019/179861
- WO-A2-2020/109225

## Beschreibung

### Hintergrund der Erfindung

Die Erfindung betrifft ein reflektierendes optisches Element, insbesondere zur Reflexion von EUV-Strahlung, umfassend: ein Substrat sowie eine reflektierende Beschichtung, die auf das Substrat aufgebracht ist. Die Erfindung betrifft auch eine optische Anordnung, bevorzugt für die Mikrolithographie, insbesondere für die EUV-Lithographie, beispielsweise in Form einer Projektionsbelichtungsanlage, die mindestens ein solches reflektierendes optisches Element aufweist. Die Erfindung betrifft auch ein Verfahren zum Herstellen eines reflektierenden optischen Elements, umfassend: Bereitstellen eines Substrats, sowie Aufbringen einer reflektierenden Beschichtung auf das Substrat, wobei bevorzugt vor dem Aufbringen der reflektierenden Beschichtung eine strukturierbare Schicht auf das Substrat aufgebracht und nach dem Aufbringen strukturiert wird.

Bei der optischen Anordnung kann es sich beispielsweise um eine optische Anordnung für die EUV-Lithografie handeln, d.h. um ein optisches System, welches auf dem Gebiet der EUV-Lithographie eingesetzt werden kann. Neben einer Projektionsbelichtungsanlage für die EUV-Lithographie, die zur Herstellung von Halbleiterbauelementen dient, kann es sich bei der optischen Anordnung beispielsweise um ein Inspektionssystem zur Inspektion einer in einer solchen Projektionsbelichtungsanlage verwendeten Photomaske (im Folgenden auch Retikel genannt), zur Inspektion eines zu strukturierenden Halbleitersubstrats (im Folgenden auch Wafer genannt) oder um ein Metrologiesystem handeln, welches zur Vermessung einer Projektionsbelichtungsanlage für die EUV-Lithographie oder von Teilen davon, beispielsweise zur Vermessung einer Projektionsoptik, eingesetzt wird.

EUV-Lithografie-Systeme bzw. EUV-Metrologie-Systeme sowie die darin verbauten Komponenten werden in Vakuum mit einer Beimischung von Wasserstoff betrieben, der einen geringen Partialdruck aufweist. Der Wasserstoff dient einer kontinuierlichen Reinigung der Optikoberflächen. Im Betrieb entstehen bei Anregung von molekularem Wasserstoff durch das erzeugte EUV-Licht Wasserstoff-Radikale (H*) und Wasserstoff-Ionen (H+). Durch Wechselwirkung dieser Wasserstoffspezies mit freiliegenden Oberflächen von reflektierenden optischen Elementen (EUV-Spiegeln) z.B. aus Si-haltigen Materialien (ein-/polykristallines bzw. amorphes Silizium, Quarzglas, Siliziumnitrid, Siliziumcarbid, insbesondere mit Silizium infiltrierter Siliziumcarbid-Verbundstoff (SiSiC), Magnesium-Aluminium-Silikat-Keramiken wie Cordieritkeramiken, Gläser bzw. Glaskeramiken mit sehr niedriger thermischer Ausdehnung, wie beispielsweise ULE^{®}, Zerodur^{®}, Clearceram^{®} etc.) entstehen volatile Hydride, insbesondere Silane, was auch als HIO ("hydrogen induced outgassing") bezeichnet wird. Die volatilen Hydride können sich wieder auf optischen Flächen niederschlagen, was zur Degradation der Optikkomponenten führt.

Aus der Literatur sind verschiedene Ansätze bekannt, wie die Bildung von volatilen Hydriden verhindert oder gemindert werden kann.

In der DE102015215014A1 wird vorgeschlagen, die der Wasserstoff-haltiger Atmosphäre ausgesetzten Komponenten einer EUV-Lithographieanlage zumindest teilweise mit einer Schutzschicht aus einem Edelmetall (aus der Gruppe Rhodium, Ruthenium, Iridium, Palladium und Platin) zu bedecken. Die minimale Dicke der Schutzschicht soll so gewählt sein, dass die Schutzschicht nicht von Wasserstoff-Ionen und/oder von Wasserstoff-Radikalen durchdrungen werden kann.

In WO2019025162A1 ist ein optisches Element offenbart, wobei an mindestens einem Oberflächenbereich dessen Grundkörpers eine durch einen Spalt getrennte Abschirmung angebracht ist, die vor einer Ätzwirkung des umgebenden Wasserstoff-Plasmas schützt. Der Abstand zwischen der Abschirmung und dem Oberflächenbereich ist kleiner als das Doppelte der Debye-Länge des umgebenden Plasmas. Die Abschirmung kann auch mittelbar oder unmittelbar auf den Grundkörper aufgebracht werden. Die Abschirmung kann aus einem Wasserstoff-Rekombinationsmaterial (z.B. Ir, Ru, Pt, Pd) bestehen oder eine Beschichtung aus einem Wasserstoff-Rekombinationsmaterial aufweisen. Der Spalt kann teilweise oder vollständig mit einem Füllmaterial (beispielweise Aluminiumoxid, Zirkonnitrid, Yttriumoxid, Ceroxid, Zirkonoxid, Nioboxid, Titanoxid, Tantaloxid, Wolframoxid, Metalle, bevorzugt Edelmetalle, insbesondere Ru, Rh, Pd, Ir, Pt, Au und deren Zusammensetzungen) gefüllt sein. In einer weiteren Ausführungsform kann die Abschirmung als Beschichtung ausgebildet sein.

In DE102017222690 A1 ist ein optisches Element zur Reflexion von EUV-Strahlung offenbart, das eine oberste Schicht aus einem Wasserstoff-Desorptionsmaterial aufweist, das eine Desorptionstemperatur für Wasserstoff von weniger als 340 K aufweist (z.B. Pd, Ag, Au sowie deren Legierungen). Zur Erzeugung des gewünschten Effekts der Freisetzung von Wasserstoff muss die oberste Schicht nicht zwingend eine geschlossene Schicht bilden. Cluster- bzw. inselförmige Materialansammlungen des Wasserstoff-Desorptionsmaterials können diesen Zweck ebenfalls erfüllen, sofern diese einen ausreichend geringen Abstand voneinander aufweisen.

In WO2019179861 A1 ist ein EUV-Spiegel offenbart, der im Betrieb einem Wasserstoff-Plasma ausgesetzt ist, wobei der Grundkörper mindestens ein Material enthält, das beim Kontakt des Oberflächenbereichs mit dem aktivierten Wasserstoff (H+, H*) mindestens ein flüchtiges Hydrid bildet. An dem Oberflächenbereich sind Edelmetall-Ionen (beispielsweise Rh, Ru, Ir, Au, Pd, Pt) in den Grundkörper implantiert, um die Bildung des flüchtigen Hydrids zu verhindern. Durch die Implantation von Edelmetall-Ionen im oberflächennahen Volumenbereich unterhalb der Oberfläche kann die Bildung von flüchtigen Hydriden deutlich reduziert werden. Hierbei wird ausgenutzt, dass Edelmetall-Ionen in der Regel eine starke katalytische Wirkung für die Rekombination von aktiviertem Wasserstoff, d.h. von Wasserstoff-Radikalen und/oder von Wasserstoff-Ionen, zu atomarem Wasserstoff aufweist. Im Gegensatz zu den weiter oben beschriebenen Lösungen erfolgt bei der Implantation der Edelmetall-Ionen lediglich eine Dotierung des Grundkörpers, aber keine Schichtbildung.

Die Implantation von Edelmetall-Ionen in einen oberflächennahen Volumenbereich eines Grundkörpers bietet jedoch nur einen eingeschränkten Schutz, wenn es z.B. sich bei dem reflektierenden optischen Element um eine strukturierte Optik handelt. Bei einer derartigen Optik wird eine strukturierbare Schicht z.B. aus amorphem Silizium auf ein Substrat aufgebracht, um eine Strukturierung beispielsweise in Form einer Gitterstruktur zu bilden. Die Gitterstruktur kann beispielsweise an einem EUV-Kollektorspiegel gebildet sein und als Spektralfilter dienen. Da eine vollständige, homogene Bedeckung strukturierter Oberflächen abzuscheiden sehr schwierig ist (oft weist die Schicht an steilen Kanten Poren, Kanäle oder andere Defekte bzw. Unregelmäßigkeiten) auf, ist eine derartige strukturierte Schicht wie auch Siliziumlagen in der reflektierenden mehrlagigen Mo-Si Schicht bzw. Beschichtung einem Ätzangriff von reaktiven Wasserstoffspezies ausgesetzt.

Aus der WO2020109225A2 ist ein Spiegel für eine Beleuchtungsoptik einer Projektionsbelichtungsanlage mit einem Spektralfilter in Form einer Gitterstruktur bekannt geworden. Die Gitterstruktur kann vollständig von einer geschlossenen Schutzschicht in Form einer reflektierenden Beschichtung überdeckt sein, die eine Mehrzahl von Si-Mo-Doppellagen aufweist. Durch eine geringe Kantensteilheit der Gitterstruktur kann die Bedeckung der Gitterstruktur mit der Schutzschicht verbessert und auf diese Weise die Wasserstoffstabilität des reflektierenden optischen Elements erhöht werden.

Soll eine vollständige Bedeckung der Gitterstruktur auch bei einer größeren Kantensteilheit erreicht werden, kann die reflektierende Mehrlagen-Beschichtung als oberflächentreue (konformale) Beschichtung aufgebracht werden, wie dies in der WO 2013113537A2 beschrieben ist. Dort wird ein konformaler bzw. isotroper Beschichtungsprozess in Form der Atomlagenabscheidung vorgeschlagen, um auch entlang eines dreidimensionalen Profils im Wesentlichen konstante Schichtdicken zu erzeugen. Die Aufbringung einer reflektierenden Mehrlagen-Beschichtung, die mehr als 50 Doppellagen aus Mo bzw. Si aufweisen kann, durch Atomlagenabscheidung ist jedoch sehr aufwändig.

In der DE 10 2019 212 910.2 ist ein optisches Element beschrieben, das ein Schutzlagensystem mit einer ersten Lage, eine zweiten Lage und eine dritten Lage aufweist. In mindestens eine Lage des Schutzlagensystems können metallische Teilchen und/oder Ionen implantiert sein. Bei den Ionen kann es sich um Metall-Ionen, z.B. um Edelmetall-Ionen, insbesondere um Platinmetall-Ionen, handeln. Mindestens eine Lage des Schutzlagensystems kann mit metallischen (Nano-)Teilchen, z.B. mit (Fremd-)Atomen in Form von Edelmetall-Teilchen (z.B. Pd, Pt, Rh, Ir) dotiert sein. Die Edelmetall-Ionen bzw. Fremdatome können als Wasserstoff- und/oder als Sauerstoff-Blocker dienen.

Alle oben beschriebenen Ansätze sehen eine großflächige Prozessierung von dreidimensionalen Objekten in komplizierter Form vor, was mit erheblichem Aufwand verbunden ist.

### Aufgabe der Erfindung

Aufgabe der Erfindung ist es, ein reflektierendes optisches Element, eine optische Anordnung und ein Verfahren zum Herstellen eines optischen Elements anzugeben, welche einen Schutz vor reaktiven Spezies, insbesondere von reaktiven Wasserstoffspezies, ermöglichen, der mit geringem Aufwand realisierbar ist.

### Gegenstand der Erfindung

Diese Aufgabe wird gemäß einem ersten Aspekt gelöst durch ein optisches Element der eingangs genannten Art, definiert durch die Merkmale des Anspruchs 1.

Der Erfinder hat erkannt, dass eine Dotierung des Materials des Substrats mit einem Wasserstoff-Rekombinationsmaterial in Form eines Edelmetalls viel effizienter bereits während des Herstellungsprozesses des Substrats erfolgen kann als dies durch eine nachträgliche Implantierung von Edelmetall-Ionen in einen oberflächennahen Volumenbereich der Fall ist, wie dies in der eingangs zitierten WO2019179861 A1 beschrieben ist.

Im Gegensatz zum dort beschriebenen Grundkörper ist beim dem erfindungsgemäßen reflektierenden optischen Element die Dotierung mit dem Edelmetall nicht auf einen oberflächennahen Volumenbereich mit einer Implantationstiefe von weniger als 1000 nm beschränkt. Das Substrat ist vielmehr auch im Volumen mit dem Edelmetall dotiert, d.h. auch in einem Volumenbereich, der einen Abstand zur Oberfläche des Substrats von mehr als 1 mm, 2 mm, 5 mm, ... aufweist. Insbesondere kann das Substrat in seinem gesamten Volumen mit dem Edelmetall dotiert sein.

Bei einer Ausführungsform ist das Substrat aus einem Glas bzw. einer Glaskeramik mit sehr niedriger thermischer Ausdehnung, wie beispielsweise titandotiertem Quarzglas (ULE^{®}), Zerodur^{®}, Clearceram^{®} etc. einer Keramik, beispielsweise einer Siliziumnitrid-Keramik, einer Siliziumcarbid-Keramik, einer Silizium-Carbonitrid-Keramik, einer Magnesium-Aluminium-Silikat-Keramik, insbesondere einer Cordieritkeramik, oder aus einem Verbundwerkstoff, insbesondere mit Silizium infiltriertem Siliziumcarbid-Verbundwerkstoff (SiSiC), gebildet. Grundsätzlich können alle in der EUV-Lithografie verwendeten Substrat-Materialien mit einem Edelmetall dotiert werden.

Bevorzugt ist das Substrat aus Silizium, insbesondere aus monokristallinem, quasi-monokristallinem oder poly-kristallinem Silizium, oder ggf. aus amorphem Silizium, gebildet. Mit Edelmetallen in Form von Gold (vgl. den Artikel "Properties of Gold-Doped Silicon", C. B. Collins et al., Phys. Rev. 105 (1957) 1168-1173) oder in Form von Platin dotiertes Silizium ist kommerziell verfügbar und kann somit für die Herstellung des Substrats des reflektierenden optischen Elements verwendet werden. Mit Gold bzw. mit Platin gesättigtes monokristallines Silizium findet Anwendungen beispielsweise in der Mikrowellentechnik als Fenster für Hochleistungs-Generatoren (vgl. den Artikel "Radiation effects on dielectric losses of Au-doped silicon", J. Molla et al., Journal of Nuclear Materials, 258-263 (1998) 1884-1888) bzw. in Strahlungsdetektoren (vgl. den Artikel "Gold and Platinum Doped Radiation Resistant Silicon Diode Detectors", R. L. Dixon et al., Radiation Protection Dosimetry 17 (1986) 527-530).

Einkristallines Silizium ist zudem ein beliebtes Material zur Herstellung von Substraten für Röntgen-, EUV- und Synchrotron-Optiken, die Poliertechnologie dafür ist gut beherrscht. Bei der Herstellung von einkristallinem Silizium kommen alle klassischen Methoden, wie das Czochralski-Verfahren (vgl. "Ein neues Verfahren zur Messung der Kristallisationsgeschwindigkeit der Metalle", J. Czochralski, Zeitschrift für physikalische Chemie, 92 (1918) 219-221) oder das Bridgeman-Stockbarger-Verfahren (vgl. "Certain Physical Properties of Single Crystals of Tungsten, Antimony, Bismuth, Tellurium, Cadmium, Zinc, and Tin", P.W. Bridgeman, Proceedings of the American Academy of Arts and Sciences 60 (1925) 305-383), in Frage. Diese Verfahren sind auch zur Herstellung von Gold- bzw. Platin-gesättigtem monokristallinem Silizium geeignet.

Für besonders große Kristalle wurde von der Fa. Schott Solar AG ein Verfahren zur Herstellung von quasi-monokristallinem Silizium (DE102012100147 A1, DE102012102597 A1) entwickelt, welches auf dem Vertical-Gradient-Freeze-Verfahren (VGF-Verfahren) basiert. Dieses Verfahren bzw. das VGF-Verfahren ist zur Herstellung von Gold- bzw. Platin-gesättigtem quasi-monokristallinem Silizium geeignet.

Ein nicht unter die Erfindung fallendes Beispiel betrifft ein reflektierendes optisches Element der eingangs genannten Art, welches insbesondere mit dem reflektierenden optischen Element gemäß dem ersten Aspekt der Erfindung kombiniert werden kann. Das reflektierende optische Element umfasst eine strukturierte Schicht, die zwischen dem Substrat und der reflektierenden Beschichtung gebildet ist und die bevorzugt eine Gitterstruktur ausbildet bzw. aufweist, wobei die strukturierte Schicht mit (mindestens) einem Edelmetall dotiert ist.

Wie weiter oben beschrieben wurde, kann die reflektierende Beschichtung eine Schutzschicht für die strukturierte Schicht bilden, welche den Ätzangriff von reaktiven Wasserstoffspezies und somit das Ausgasen von volatilen Hydriden verhindert oder zumindest begrenzt. Für den Fall, dass die Flanken der Gitterstruktur eine zu große Flankensteilheit von mehr als z.B. 60° aufweisen, wird die strukturierte Schicht jedoch in der Regel nicht mehr vollständig von der reflektierenden Beschichtung überdeckt, sofern diese nicht in einem aufwändigen isotropen Beschichtungsverfahren, z.B. durch Atomlagendeposition, aufgebracht wird.

Durch die Dotierung der strukturierten Schicht, die z.B. aus amorphem Silizium gebildet sein kann (vgl. die eingangs zitierte WO2020109225A2) mit einem Edelmetall, das als Wasserstoff-Rekombinationsmaterial dient, kann die strukturierte Schicht dennoch vor dem Angriff von Wasserstoff geschützt werden. Um die Dotierung mit dem Edelmetall zu bewirken, kann beim Aufbringen der strukturierten bzw. einer strukturierbaren Schicht durch Sputter-Deposition ein mit dem Edelmetall dotiertes Sputter-Target verwendet werden, wie dies weiter unten näher beschrieben wird.

Ein weiteres nicht unter die Erfindung fallendes Beispiel betrifft ein reflektierendes optisches Element der eingangs genannten Art, welches insbesondere mit dem reflektierenden optischen Element des ersten Aspekts und/oder des zweiten Aspekts kombiniert werden kann und bei dem die reflektierende Beschichtung, insbesondere mindestens eine Silizium-Lage einer reflektierenden Mo-Si Beschichtung, mit einem Edelmetall dotiert ist.

Insbesondere wenn die reflektierende Beschichtung auf eine strukturierte Schicht aufgebracht ist oder wenn die reflektierende Beschichtung selbst strukturiert ist und beispielsweise eine Gitterstruktur bildet, kann es zu einer Unterätzung einzelner Schichten der reflektierenden Beschichtung kommen, wie die beispielsweise in dem Artikel "Multilayer EUV optics with integrated IR suppression gratings", T. Feigl et al., Proceedings of 2016 EUVL Workshop (P69), Berkeley, June 13-16, 2016, gezeigt ist. Die Unterätzung erfolgt in diesem Fall typischerweise an den seitlichen Flanken der (strukturierten) reflektierenden Beschichtung, üblicherweise an einzelnen Lagen der reflektierenden Beschichtung, die für einen Ätzangriff besonders anfällig sind.

Bei einer Weiterbildung enthält die strukturierte Schicht und/oder die reflektierende Beschichtung Silizium, das mit dem Edelmetall dotiert ist. Wie weiter oben beschrieben wurde, kann es sich bei dem Material der strukturierten Schicht beispielsweise um amorphes Silizium handeln, das sich vergleichsweise einfach strukturieren lässt. Für den Fall, dass es sich bei der reflektierenden Beschichtung um eine Mehrlagen-Beschichtung handelt, wie sie für die Reflexion von EUV-Strahlung unter normalen Einfallswinkeln (kleiner 45°) verwendet wird, kann diese - abhängig von der Betriebswellenlänge, für welche die reflektierende Beschichtung ausgelegt ist - alternierende Lagen (Doppellagen) aus Mo und Si aufweisen. Wie weiter oben beschrieben wurde, kann Silizium beim Kontakt mit Wasserstoff flüchtige Silane bilden. Die Bildung von Silanen kann durch die Dotierung der Si-Lagen der reflektierenden Mo-Si-Beschichtung mit dem Edelmetall verhindert oder zumindest vermindert werden. Die reflektierende Beschichtung, genauer gesagt einzelne Lagen der reflektierenden Beschichtung, können schon bei der Abscheidung mit dem Edelmetall dotiert werden, wenn bei einer Sputter-Deposition ein mit dem Edelmetall dotiertes Sputter-Target verwendet wird (s.u.).

Bei der Dotierung von Silizium mit einem Edelmetall ist bei den bevorzugt verwendeten Dotierkonzentrationen (s.u.) nicht mit einer signifikanten Erhöhung der Absorption des dotierten Siliziums zu rechnen, so dass durch die Dotierung eine mit wenig Aufwand eine verbesserte HIO- und Strahlungsbeständigkeit erreicht werden kann.

Bei einer weiteren Ausführungsform bildet die reflektierende Beschichtung eine Mehrlagen-Beschichtung zur Reflexion von EUV-Strahlung. Eine solche Mehrlagen-Beschichtung weist typischerweise eine Mehrzahl von alternierenden Lagen aus einem Material mit einem hohen Realteil des Brechungsindex bei der Betriebswellenlänge und eine Material mit einem niedrigen Realteil des Brechungsindex bei der Betriebswellenlänge auf. Bei den Materialien kann es sich beispielsweise um Silizium und Molybdän handeln, abhängig von der Betriebswellenlänge sind aber auch andere Materialkombinationen möglich.

Bei einer weiteren Ausführungsform ist das Edelmetall ausgewählt aus der Gruppe umfassend: Ru, Rh, Pd, Ag, Os, Ir, Pt, Au und deren Kombinationen bzw. Legierungen. Wie weiter oben beschrieben wurde, weisen Edelmetalle in der Regel eine starke katalytische Wirkung für die Rekombination von aktiviertem Wasserstoff, d.h. von Wasserstoff-Radikalen und/oder von Wasserstoff-Ionen, zu molekularem Wasserstoff auf. Wie ebenfalls weiter oben beschrieben wurde, kann insbesondere mit Pt oder Au dotiertes Silizium verwendet werden, da dieses kommerziell verfügbar ist. Es versteht sich aber, dass auch andere Materialien, die das Volumen eines Substrats, eine strukturierte Schicht und/oder eine reflektierende Beschichtung bilden bzw. in diesen enthalten sind, mit Edelmetallen dotiert werden können.

Bei einer weiteren Ausführungsform liegt eine Dotierungskonzentration des Edelmetalls in dem Volumen des Substrats, in der strukturierten Schicht und/oder in der reflektierenden Beschichtung zwischen 10¹⁰ cm⁻³ und 10²⁰ cm⁻³, bevorzugt zwischen 10¹² cm⁻³ und 10¹⁶ cm⁻³. Die angegebenen Dotierkonzentrationen ermöglichen eine Dotierung der strukturierten Schicht bzw. der reflektierenden Beschichtung mit einem Edelmetall, beispielsweise mit Au oder Pt, ohne dass es zu einer signifikanten Erhöhung der Absorption von EUV-Strahlung kommt. Auch für die Dotierung des Substrats hat sich der oben angegebene Wertebereich der Dotierkonzentration als günstig erwiesen.

Bei einer weiteren Ausführungsform ist das reflektierende optische Element als Kollektorspiegel für eine Beleuchtungsoptik einer Projektionsbelichtungsanlage ausgebildet. Ein solcher Kollektorspiegel kann beispielsweise eine oder mehrere ellipsoidale und/oder hyperboloide Reflexionsflächen aufweisen, die der Fläche mit der reflektierenden Beschichtung entsprechen. Die Reflexionsfläche des Kollektorspiegels kann im streifenden Einfall (Grazing Incidence, GI), also mit Einfallswinkeln größer als 45°, oder im normalen Einfall (Normal Incidence, NI), also mit Einfallwinkeln kleiner als 45°, mit Beleuchtungsstrahlung beaufschlagt werden.

Der Kollektorspiegel weist typischerweise eine strukturierte Schicht in Form einer Gitterstruktur auf, die als Spektralfilter dient, um Falschlicht, d.h. Strahlung bei Wellenlängen außerhalb des EUV-Wellenlängenbereichs, z.B. im infraroten Wellenlängenbereich, zu unterdrücken. Es versteht sich, dass das reflektierende optische Element nicht zwingend als Kollektorspiegel ausgebildet sein muss, sondern dass es sich auch um ein anderes reflektierendes optisches Element handeln kann.

Ein weiterer Aspekt der Erfindung betrifft eine optische Anordnung, bevorzugt eine Projektionsbelichtungsanlage für die Mikrolithographie, insbesondere für die EUV-Lithographie, umfassend: mindestens ein reflektierendes optisches Element, das wie weiter oben beschrieben ausgebildet ist. Eine solche Projektionsbelichtungsanlage umfasst eine Beleuchtungsoptik zur Überführung von Beleuchtungsstrahlung von einer Strahlungsquelle auf ein Retikel mit abzubildenden Strukturen, sowie eine Projektionsoptik zur Abbildung der Strukturen des Retikels auf einen Wafer. Das reflektierende optische Element kann in der Beleuchtungsoptik angeordnet sein, es ist aber auch eine Anordnung in der Projektionsoptik möglich.

Wie weiter oben beschrieben wurde, ist das reflektierende optische Element in einer solchen Projektionsbelichtungsanlage in einer Vakuum-Umgebung mit einer Beimischung von Wasserstoff mit niedrigem Partialdruck angeordnet. Im Betrieb der Projektionsbelichtungsanlage entstehen durch die Wechselwirkung mit der EUV-Strahlung reaktive Wasserstoffspezies. Durch die Dotierung des Substrats, der strukturierten Schicht und/oder der reflektierenden Beschichtung mit dem Edelmetall kann mit wenig Aufwand sowohl eine verbesserte HIO- als auch Strahlungsbeständigkeit des Substrats, der strukturierten Schicht und/oder der reflektierenden Beschichtung erreicht werden.

Ein weiterer Aspekt der Erfindung betrifft ein Verfahren der eingangs genannten Art, bei dem die reflektierende Beschichtung und/oder die strukturierbare Schicht durch Sputter-Deposition aufgebracht wird/werden, wobei bei der Sputter-Deposition ein mit einem Edelmetall dotiertes Sputter-Target verwendet wird, das bevorzugt Silizium enthält.

Bei der Sputter-Deposition wird ein Festkörper-Material (Sputter-Target) mit energiereichen Ionen beschossen. Hierbei werden Teilchen bzw. Atome aus dem Sputter-Target herausgelöst, gehen in die Gasphase über scheiden sich auf einem zu beschichtenden Körper (Substrat) ab. Damit die aus dem Sputter-Target herausgelösten Atome das Substrat erreichen, findet die Sputter-Deposition üblicherweise in einer Prozess-Kammer statt, in der ein Hochvakuum herrscht. Bei den energiereichen Ionen kann es sich beispielsweise um Edelgasionen, insbesondere um Argon-Ionen, handeln. Bei der Sputter-Deposition existieren mehrere Varianten.

Bei der Gleichspannungs-Sputter-Deposition wird zwischen dem Sputter-Target und dem Substrat eine Gleichspannung angelegt, um ein Plasma zu erzeugen und die positiv geladenen Edelgas-Ionen zum Sputter-Target (Kathode) sowie die negativ geladenen Teilchen, die aus dem Sputter-Target herausgeschlagen werden, zum Substrat (Anode) zu beschleunigen. Beim Magnetron-Sputtern wird dem elektrischen Feld ein Magnetfeld überlagert, um die Ionisierungsrate zu erhöhen. Weitere Varianten der Sputter-Deposition, mit denen die Abscheidung ebenfalls erfolgen kann, sind beispielsweise HF-Sputtern, reaktives Sputtern, Ionenstrahl-Sputtern oder Atomstrahl-Sputtern.

Wie weiter oben beschrieben wurde, kann ein Sputter-Target, welches zur Sputter-Deposition einer zu strukturierenden Schicht bzw. von Lagen der reflektierenden Beschichtung dient, mit einem Edelmetall dotiert werden. Zu diesem Zweck können beispielsweise Sputter-Targets aus Gold- oder Platindotiertem Silizium hergestellt und für die Sputter-Deposition von strukturierbaren Schichten bzw. von reflektierenden Beschichtungen verwendet werden. Hierbei kann ausgenutzt werden, dass Gold- oder Platin-dotiertes Silizium kommerziell erhältlich ist. Es versteht sich aber, dass das Sputter-Target auch mit anderen Edelmetallen dotiert sein kann.

Ein weiterer Aspekt der Erfindung betrifft ein Verfahren der eingangs genannten Art, das insbesondere mit dem oben beschriebenen Verfahren kombiniert werden kann. Bei dem Verfahren ist das Substrat, das zur nachfolgenden Beschichtung bereitgestellt wird, in seinem Volumen mit mindestens einem Edelmetall dotiert. In diesem Fall wird das Substrat bereits bei seiner Herstellung mit dem mindestens einen Edelmetall dotiert und das dotierte Substrat wird für die Beschichtung bereitgestellt.

Die Beschichtung mit der reflektierenden Beschichtung und ggf. mit der strukturierbaren Schicht kann bei diesem Aspekt ebenfalls mit Hilfe eines Sputter-Targets erfolgen, das mit einem Edelmetall dotiert ist, dies ist aber nicht zwingend der Fall. Insbesondere für den Fall, dass das reflektierende optische Element keine strukturierte bzw. strukturierbare Schicht aufweist, kann eine herkömmliche, nicht mit einem Edelmetall dotierte reflektierende Beschichtung auf das Substrat aufgebracht werden.

Es versteht sich, dass das reflektierende optische Element nicht zwingend zur Reflexion von Strahlung im EUV-Wellenlängenbereich ausgebildet sein muss, sondern auch zur Reflexion von Strahlung in anderen Wellenlängenbereichen ausgebildet sein kann, beispielsweise zur Reflexion von Strahlung im VUV-Wellenlängenbereich.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigt
- Fig. 1: schematisch im Meridionalschnitt eine Projektionsbelichtungsanlage für die EUV-Lithografie,
- Fig. 2: eine schematische Darstellung eines reflektierenden optischen Elements der Projektionsbelichtungsanlage von Fig. 1 mit einem Substrat, das mit einem Edelmetall dotiert ist,
- Fig. 3: eine schematische Darstellung analog zu Fig. 2, bei der das reflektierende optische Element eine strukturierte Schicht aufweist, die mit einem Edelmetall dotiert ist, sowie
- Fig. 4: eine schematische Darstellung einer Sputter-Depositionsanlage mit einem Sputter-Target, das mit einem Edelmetall dotiert ist.

In der folgenden Beschreibung der Zeichnungen werden für gleiche bzw. funktionsgleiche Bauteile identische Bezugszeichen verwendet.

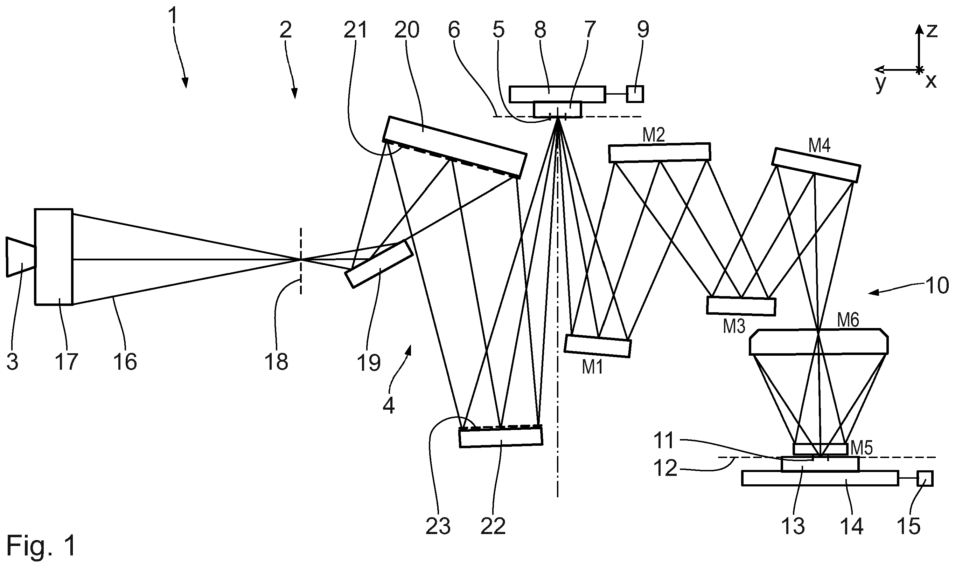

Im Folgenden werden unter Bezugnahme auf Fig. 1 exemplarisch die wesentlichen Bestandteile einer Projektionsbelichtungsanlage 1 für die Mikrolithographie beschrieben. Die Beschreibung des grundsätzlichen Aufbaus der Projektionsbelichtungsanlage 1 sowie deren Bestandteile ist hierbei nicht einschränkend zu verstehen.

Ein Beleuchtungssystem 2 der Projektionsbelichtungsanlage 1 hat neben einer Strahlungsquelle 3 eine Beleuchtungsoptik 4 zur Beleuchtung eines Objektfeldes 5 in einer Objektebene 6. Belichtet wird hierbei ein im Objektfeld 5 angeordnetes Retikel 7. Das Retikel 7 ist von einem Retikelhalter 8 gehalten. Der Retikelhalter 8 ist über einen Retikelverlagerungsantrieb 9 insbesondere in einer Scanrichtung verlagerbar.

In Fig. 1 ist zur Erläuterung ein kartesisches xyz-Koordinatensystem eingezeichnet. Die x-Richtung verläuft senkrecht zur Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrrieb 15 kann synchronisiert zueinander erfolgen.

Bei der Strahlungsquelle 3 handelt es sich um eine EUV-Strahlungsquelle. Die Strahlungsquelle 3 emittiert insbesondere EUV-Strahlung 16, welche im Folgenden auch als Nutzstrahlung oder Beleuchtungsstrahlung bezeichnet wird.

Die Nutzstrahlung hat insbesondere eine Wellenlänge im Bereich zwischen 5 nm und 30 nm. Bei der Strahlungsquelle 3 kann es sich um eine Plasmaquelle handeln, zum Beispiel um eine LPP (Laser Produced Plasma, mithilfe eines Lasers erzeugtes Plasma)-Quelle oder um eine DPP (Gas Discharged Produced Plasma, mittels Gasentladung erzeugtes Plasma)-Quelle. Es kann sich auch um eine synchrotronbasierte Strahlungsquelle handeln. Bei der Strahlungsquelle 3 kann es sich um einen Freie-Elektronen-Laser (Free-Electron-Laser, FEL) handeln.

Die Beleuchtungsstrahlung 16, die von der Strahlungsquelle 3 ausgeht, wird von einem Kollektorspiegel 17 gebündelt. Bei dem Kollektorspiegel 17 kann es sich um einen Kollektorspiegel mit einer oder mit mehreren ellipsoidalen und/oder hyperboloiden Reflexionsflächen handeln. Die mindestens eine Reflexionsfläche des Kollektorspiegels 17 kann im streifenden Einfall (Grazing Incidence, GI), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektorspiegel 17 kann einerseits zur Optimierung seiner Reflektivität für die Nutzstrahlung und andererseits zur Unterdrückung von Falschlicht strukturiert und/oder beschichtet sein.

Nach dem Kollektorspiegel 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektorspiegel 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Der erste Facettenspiegel 20 umfasst eine Vielzahl von einzelnen ersten Facetten 21, welche im Folgenden auch als Feldfacetten bezeichnet werden. Von diesen Facetten 21 sind in der Fig. 1 nur beispielhaft einige dargestellt. Im Strahlengang der Beleuchtungsoptik 4 ist dem ersten Facettenspiegel 20 nachgeordnet ein zweiter Facettenspiegel 22. Der zweite Facettenspiegel 22 umfasst eine Mehrzahl von zweiten Facetten 23.

Die Beleuchtungsoptik 4 bildet somit ein doppelt facettiertes System. Dieses grundlegende Prinzip wird auch als Fliegenaugeintegrator (Fly's Eye Integrator) bezeichnet. Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Der vorletzte Spiegel M5 und der letzte Spiegel M6 haben jeweils eine Durchtrittsöffnung für die Beleuchtungsstrahlung 16. Bei der Projektionsoptik 10 handelt es sich um eine doppelt obskurierte Optik. Die Projektionsoptik 10 hat eine bildseitige numerische Apertur, die größer ist als 0,5 und die auch größer sein kann als 0,6 und die beispielsweise 0,7 oder 0,75 betragen kann.

Die Spiegel Mi können, genauso wie die Spiegel der Beleuchtungsoptik 4, eine hoch reflektierende Beschichtung für die Beleuchtungsstrahlung 16 aufweisen.

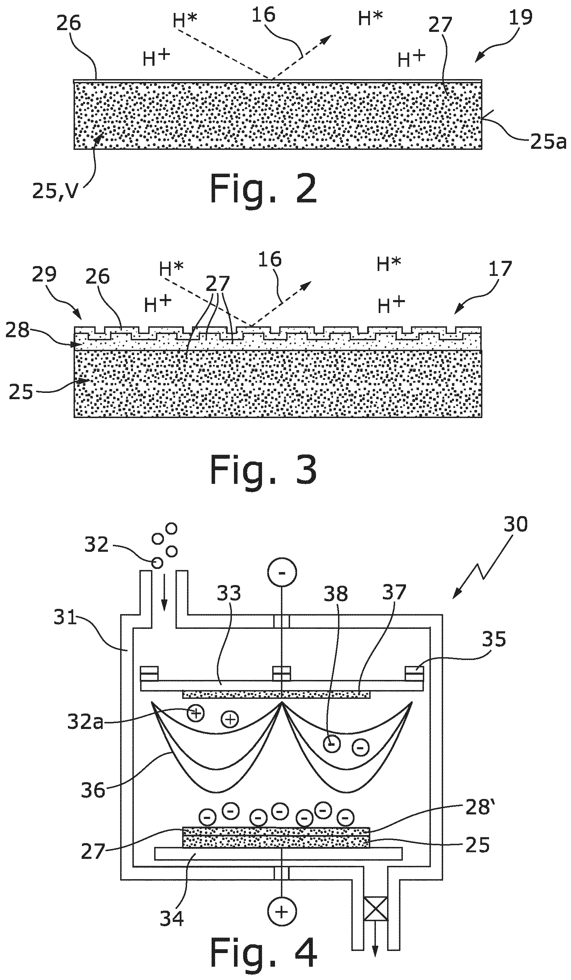

Fig. 2 zeigt den Umlenkspiegel 19 der Beleuchtungsoptik 4, der ein Substrat 25 aus monokristallinem Silizium aufweist, auf das eine reflektierende Beschichtung 26 zur Reflexion der Beleuchtungsstrahlung 16 aufgebracht ist.

Der Umlenkspiegel 19 ist reaktiven Wasserstoffspezies in Form von Wasserstoff-Ionen (H+) und Wasserstoff-Radikalen (H*) ausgesetzt. Die reaktiven Wasserstoffspezies H+, H* können an freiliegenden, beispielsweise seitlichen Oberflächen 25a des Substrats 25 mit dem Silizium-Material des Substrats 25 reagieren und volatile Hydride, z.B. in Form von Silanen, bilden. Die volatilen Hydride können sich wieder auf optischen Flächen niederschlagen, was zu deren Degradation führt.

Um der Bildung von volatilen Hydriden entgegenzuwirken, ist das Substrat 25 des Umlenkspiegels 19 bei dem in Fig. 2 gezeigten Beispiel in seinem gesamten Volumen V mit einem Edelmetall 27, genauer gesagt mit Gold, dotiert. Das Edelmetall 27 in Form von Gold-Atomen, die in das Silizium-Substrat 25 implantiert sind, dient als Wasserstoff-Rekombinationsmaterial, und führt dazu, dass die reaktiven Wasserstoffspezies H+, H* zu molekularem Wasserstoff reagieren und daher der Bildung von volatilen Hydriden entgegenwirkt.

Die Dotierung des Substrats 25 mit den Gold-Atomen ist bei der Herstellung des monokristallinen Silizium-Subtrats 25 erfolgt. Das monokristalline Silizium-Substrat 25 wurde bei seiner Herstellung aus der Schmelze gezogen (Czchoralski-Verfahren). Das Material der Schmelze, aus dem das Substrat 25 gezogen wurde, war hierbei mit dem Edelmetall 27 dotiert. Eine Herstellung des monokristallinen, mit einem Edelmetall 27 dotierten Silizium-Substrats 25 auf andere Weise, z.B. mit Hilfe des Bridgeman-Stockbarger-Verfahrens, ist ebenso möglich. Auch die Herstellung eines quasi-monokristallinen Silizium-Substrats 25 oder eines polykristallinen Silizium-Substrats, das mit einem Edemetall, z.B. mit Gold, dotiert ist, ist möglich.

Die Dotierung des Silizium-Substrats 25 mit anderen Edelmetallen, beispielsweise mit Ru, Rh, Pd, Ag, Os, Ir, Pt und deren Kombinationen bzw. Legierungen ist ebenso möglich. Die Dotierung des Silizium-Substrats 25 mit Au oder mit Pt hat sich als günstig erwiesen, da derartige Materialien bereits kommerziell verfügbar sind. Es ist aber selbstverständlich ebenso möglich, das Silizium-Substrat 25 mit mindestens einem anderen Edelmetall als Au oder Pt zu dotieren.

Die weiter oben beschriebene Dotierung des Substrats 25 mit einem Edelmetall kann auch bei anderen Substrat-Materialien vorgenommen werden, die sich für die Herstellung von reflektierenden optischen Elementen für die EUV-Lithographie eignen. Bei diesen Substrat-Materialien handelt es sich beispielsweise um Quarzglas, Gläser bzw. Glaskeramiken mit sehr niedriger thermischer Ausdehnung, wie beispielsweise ULE^{®}, Zerodur^{®}, Clearceram ^{®} etc., um Keramiken z.B. Siliziumnitrid, Siliziumcarbid, insbesondere mit Silizium infiltriertem Siliziumcarbid-Verbundstoff (SiSiC), Magnesium-Aluminium-Silikat-Keramiken wie Cordieritkeramiken, etc.,. Es versteht sich, dass die Dotierung des Substrats 25 auch mit zwei oder mehr unterschiedlichen Edelmetallen 27 vorgenommen werden kann.

Fig. 3 zeigt beispielhaft den Kollektorspiegel 17 der Beleuchtungsoptik 2 der Projektionsbelichtungsanlage 1 von Fig. 1. Der Kollektorspiegel 17 unterscheidet sich von dem in Fig. 2 gezeigten Umlenkspiegel 19 dadurch, dass zwischen dem Substrat 25 und der reflektierenden Beschichtung 26 eine strukturierte Schicht 28 gebildet ist. Die strukturierte Schicht 28 weist eine strukturierte Oberfläche in Form einer Gitterstruktur 29 auf und ist aus amorphem Silizium gebildet. Die Gitterstruktur 29 dient als Spektralfilter zur Unterdrückung von Falschlicht, d.h. von Strahlung bei Wellenlängen außerhalb des EUV-Wellenlängenbereichs, z.B. im infraroten Wellenlängenbereich. Die reflektierende Beschichtung 26 ist auf die strukturierte Schicht 28 bzw. auf die Gitterstruktur 29 aufgebracht.

Grundsätzlich wird die strukturierte Schicht 28 durch die aufgebrachte reflektierende Beschichtung 26 vor den reaktiven Wasserstoffspezies H+, H* geschützt. Bei dem in Fig. 3 gezeigten Beispiel ist jedoch die (maximale) Kantensteilheit der Gitterstruktur 29 hoch und liegt bei ca. 90°. Die Aufbringung der reflektierenden Beschichtung 26 in Form einer geschlossenen Schicht, welche die strukturierte Schicht 28 vollständig überdeckt, ist auch bei einer derart großen Kantensteilheit möglich, wenn das Aufbringen durch ein isotropes Beschichtungsverfahren, z.B. durch Atomlagendeposition, erfolgt. Die Aufbringung der reflektierenden Beschichtung 26, die im gezeigten Beispiel eine Mehrlagen-Beschichtung mit einer Anzahl von ca. 50 Doppellagen aus Si/Mo bildet, mit Hilfe eines isotropen Beschichtungsverfahrens ist jedoch sehr aufwändig. Zudem ist der Kollektorspiegel 17 nicht plan ausgebildet, wie dies in Fig. 3 dargestellt ist, sondern weist typischerweise eine ellipsoidale und/oder hyperboloide Krümmung auf, was die Beschichtung durch Atomlagenabscheidung zusätzlich erschwert.

Im gezeigten Beispiel ist die reflektierende Beschichtung 26 mit einem nichtisotropen Beschichtungsverfahren, genauer gesagt durch Sputter-Deposition, auf die strukturierte Schicht 28 aufgebracht. Die strukturierte Schicht 28 ist zum Schutz vor reaktiven Wasserstoffspezies H+, H* mit einem Edelmetall 27 dotiert. Gleiches gilt für die auf die strukturierte Schicht 28 aufgebrachte reflektierende Beschichtung 26, da diese, genauer gesagt deren Silizium enthaltenden Lagen, insbesondere entlang der steilen Flanken der Gitterstruktur 29 ebenfalls reaktiven Wasserstoffspezies H+, H* ausgesetzt sind. Auf die reflektierende Beschichtung 26 kann ein nicht bildlich dargestelltes Schutzlagensystem aufgebracht sein, bei dem in einer oder in mehreren Lagen ebenfalls ein Edelmetall implantiert sein kann.

Für die effiziente Durchführung der Dotierung der strukturierten Schicht 28, der reflektierenden Beschichtung 26 sowie ggf. einer oder mehrerer Lagen des Schutzlagensystems wird eine Sputter-Deposition durchgeführt, bei der ein Sputter-Target 37 verwendet wird, das mit einem Edelmetall 27 dotiert ist, wie dies nachfolgend anhand von Fig. 4 beschrieben wird.

Fig. 4 zeigt stark vereinfacht eine Sputter-Depositionsanlage 30, die eine Prozess-Kammer 31 aufweist, in der ein Hochvakuum herrscht. Der Prozess-Kammer 31 wird über einen Gaseinlass ein Edelgas 32 in Form von Argon zugeführt. Das Edelgas 32 tritt in der Prozess-Kammer 31 in einen Zwischenraum zwischen einer plattenförmigen Kathode 33 und einer plattenförmigen Anode 34 ein, in dem ein zeitlich konstantes elektrisches Feld erzeugt wird. Für die Erzeugung des elektrischen Feldes wird eine zeitlich konstante Spannung zwischen der Kathode 33 und der Anode 34 angelegt. An einer dem Zwischenraum abgewandten Seite der Kathode 33 sind Magnete 35 angeordnet, die zusätzlich zu dem elektrischen Feld ein Magnetfeld 36 in dem Zwischenraum erzeugen.

Das Edelgas 32 wird in dem Zwischenraum zwischen der Kathode 33 und der Anode 34 ionisiert und bildet Edelgas-Ionen 32a, die zur Kathode 33 beschleunigt werden und aus einem dort angebrachten Sputter-Target 37 negativ geladene Teilchen 38 herausschlagen, die in Richtung auf die Anode 34 beschleunigt werden und sich an einem dort angebrachten Substrat 25 des reflektierenden optischen Elements 17 abscheiden.

Das Sputter-Target 37 ist im gezeigten Beispiel aus monokristallinem oder quasi-monokristallinem Silizium gebildet, das mit einem Edelmetall 27 dotiert ist. Die Dotierung bewirkt, dass eine bei der Sputter-Deposition auf dem Substrat 25 abgeschiedene strukturierbare Schicht 28' ebenfalls eine Dotierung mit dem Edelmetall 27 aufweist. Entsprechend kann auch die reflektierende Beschichtung 26, genauer gesagt können die Silizium-Lagen der reflektierenden Beschichtung 26, mit Hilfe eines mit einem Edelmetall 27 dotierten Sputter-Targets 37 aus Silizium abgeschieden werden.

Vor dem Aufbringen der reflektierenden Beschichtung 26 wird die strukturierbare Schicht 28' strukturiert, um die strukturierte Schicht 28 mit der Gitterstruktur 29 zu bilden. Die Strukturierung kann beispielsweise mit Hilfe eines trocken- oder nass-chemischen Ätzprozesses der strukturierbaren Schicht 28' unter Verwendung einer Strukturierungsschicht erfolgen. Die Strukturierungsschicht, die als Opferschicht dient, kann z.B. mit Hilfe einer lithographischen Belichtung oder auf andere Weise strukturiert werden.

Eine Dotierungskonzentration des Edelmetalls 27 im Volumen V des Substrats 25, in der strukturierten Schicht 28 und in der reflektierenden Beschichtung 26 liegt typischerweise in der Größenordnung zwischen 10¹⁰ cm⁻³ und 10²⁰ cm⁻³, insbesondere zwischen 10¹² cm⁻³ und 10¹⁶ cm⁻³. Bei einer solchen Dotierungskonzentration ist nicht mit einer signifikanten Erhöhung der Absorption des dotierten Siliziums in der reflektierenden Beschichtung 26 bzw. in der strukturierten Schicht 28 oder dem Substrat 25 zu rechnen, so dass durch die hier beschriebene Dotierung mit wenig Aufwand eine verbesserte HIO- und Strahlungsbeständigkeit des reflektierenden optischen Elements 17 erreicht werden kann.

Es versteht sich, dass die Dotierung mit dem Edelmetall 27 nicht zwingend auch in der strukturierten Schicht 28 und in der reflektierenden Beschichtung 26 erfolgen muss. Auch ist die Dotierung der strukturierten Schicht 28 ggf. nicht erforderlich, wenn diese vollständig von der reflektierenden Beschichtung 26 überdeckt ist.

## Patentansprüche

1. Reflektierendes optisches Element (17, 19), insbesondere zur Reflexion von EUV-Strahlung (16), umfassend:
ein Substrat (25), sowie
eine reflektierende Beschichtung (26), die auf das Substrat (25) aufgebracht ist, **dadurch gekennzeichnet,**
**dass** das Substrat (25) in seinem Volumen (V) in einem Volumenbereich,
der sich von einer Oberfläche des Substrats (25) bis zu einem Abstand von der Oberfläche des Substrats (25) von mehr als 1 mm erstreckt, mit mindestens einem Edelmetall (27) dotiert ist.

2. Reflektierendes optisches Element nach Anspruch 1, bei dem das Substrat (25) aus Glas, insbesondere aus titandotiertem Quarzglas, aus einer Glaskeramik, aus einer Keramik, bevorzugt einer Siliziumnitrid-Keramik, einer Siliziumcarbid-Keramik, einer Silizium-Carbonitrid-Keramik, einer Magnesium-Aluminium-Silikat-Keramik, insbesondere einer Cordieritkeramik, oder aus einem Verbundwerkstoff, insbesondere mit Silizium infiltriertem Siliziumcarbid-Verbundwerkstoff, SiSiC, gebildet ist.

3. Reflektierendes optisches Element nach Anspruch 1, bei dem das Substrat (25) aus Silizium, insbesondere aus monokristallinem, quasi-monokristallinem oder poly-kristallinem Silizium, gebildet ist.

4. Reflektierendes optisches Element nach einem der vorhergehenden Ansprüche, bei dem der Volumenbereich, in dem das Substrat (25) mit dem mindestens einen Edelmetall (27) dotiert ist, sich von der Oberfläche des Substrats (25) bis zu einem Abstand von der Oberfläche des Substrats (25) von mehr als 2 mm, insbesondere von mehr als 5 mm, erstreckt.

5. Reflektierendes optisches Element nach einem der vorhergehenden Ansprüche, bei dem das Substrat (25) in seinem gesamten Volumen mit dem mindestens einen Edelmetall (27) dotiert ist.

6. Reflektierendes optisches Element nach einem der vorhergehenden Ansprüche, bei dem die reflektierende Beschichtung (26) Silizium enthält, das mit dem Edelmetall (27) dotiert ist.

7. Reflektierendes optisches Element nach einem der vorhergehenden Ansprüche, bei dem die reflektierende Beschichtung eine Mehrlagen-Beschichtung (26) zur Reflexion von EUV-Strahlung (16) bildet.

8. Reflektierendes optisches Element nach einem der vorhergehenden Ansprüche, bei dem das Edelmetall (27) ausgewählt ist aus der Gruppe umfassend: Ru, Rh, Pd, Ag, Os, Ir, Pt, Au.

9. Reflektierendes optisches Element nach einem der vorhergehenden Ansprüche, bei dem eine Dotierungskonzentration des Edelmetalls (27) zwischen 10¹⁰ cm⁻³ und 10²⁰ cm⁻³, bevorzugt zwischen 10¹² cm⁻³ und 10¹⁶ cm⁻³ liegt.

10. Reflektierendes optisches Element nach einem der vorhergehenden Ansprüche, das als Kollektorspiegel (17) für eine Beleuchtungsoptik (2) einer Projektionsbelichtungsanlage (1) ausgebildet ist.

11. Optische Anordnung, bevorzugt Projektionsbelichtungsanlage (1) für die Mikrolithographie, insbesondere für die EUV-Lithographie, umfassend:
mindestens ein reflektierendes optisches Element (17, 19) nach einem der vorhergehenden Ansprüche.

12. Verfahren zum Herstellen eines reflektierenden optischen Elements (17, 19) nach einem der Ansprüche 1 bis 10, umfassend:
Bereitstellen eines Substrats (25),
Aufbringen einer reflektierenden Beschichtung (26) auf das Substrat (25),
**dadurch gekennzeichnet,**
**dass** das bereitgestellte Substrat (25) in seinem Volumen (V) in einem Volumenbereich, der sich von einer Oberfläche des Substrats (25) bis zu einem Abstand von der Oberfläche des Substrats (25) von mehr als 1 mm erstreckt, mit mindestens einem Edelmetall (27) dotiert ist .

## Claims

1. Reflective optical element (17, 19), especially for reflecting EUV radiation (16), comprising:
a substrate (25), and
a reflective coating (26) applied to the substrate (25),
**characterized in that**
the substrate (25) has been doped in its volume (V) with at least one precious metal (27) in a volume region that extends from a surface of the substrate (25) up to a distance from the surface of the substrate (25) of more than 1 **mm.**

2. Reflective optical element according to Claim 1, in which the substrate (25) is formed from glass, especially from titanium-doped quartz glass, from a glass ceramic, from a ceramic, preferably a silicon nitride ceramic, a silicon carbide ceramic, a silicon carbonitride ceramic, a magnesium aluminium silicate ceramic, especially a cordierite ceramic, or from a composite material, especially silicon-infiltrated silicon carbide composite, SiSiC.

3. Reflective optical element according to Claim 1, in which the substrate (25) is formed from silicon, especially from monocrystalline, quasi-monocrystalline or polycrystalline silicon.

4. Reflective optical element according to any of the preceding claims, in which the volume region in which the substrate (25) has been doped with the at least one precious metal (27) extends from the surface of the substrate (25) to a distance from the surface of the substrate (25) of more than 2 mm, especially of more than 5 mm.

5. Reflective optical element according to any of the preceding claims, in which the substrate (25) has been doped with the at least one precious metal (27) throughout its volume.

6. Reflective optical element according to any of the preceding claims, in which the reflective coating (26) contains silicon that has been doped with the precious metal (27).

7. Reflective optical element according to any of the preceding claims, in which the reflective coating forms a multilayer coating (26) for reflection of EUV radiation (16).

8. Reflective optical element according to any of the preceding claims, in which the precious metal (27) is selected from the group comprising: Ru, Rh, Pd, Ag, Os, Ir, Pt, Au.

9. Reflective optical element according to any of the preceding claims, in which a dopant concentration of the precious metal (27) is between 10¹⁰ cm⁻³ and 10²⁰ cm⁻³, preferably between 10¹² cm⁻³ and 10¹⁶ cm⁻³.

10. Reflective optical element according to any of the preceding claims, in the form of a collector mirror (17) for an illumination optical system (2) of a projection exposure apparatus (1).

11. Optical arrangement, preferably projection exposure apparatus (1) for microlithography, especially for EUV lithography, comprising:
at least one reflective optical element (17, 19) according to any of the preceding claims.

12. Method of producing a reflective optical element (17, 19) according to any of Claims 1 to 10, comprising:
providing a substrate (25),
applying a reflective coating (26) to the substrate (25),
**characterized in that**
the provided substrate (25) has been doped in its volume (V) with at least one precious metal (27) in a volume region that extends from a surface of the substrate (25) up to a distance from the surface of the substrate (25) of more than 1 mm.

## Revendications

1. Élément optique réfléchissant (17, 19), en particulier pour la réflexion d'un rayonnement EUV (16), comprenant :
un substrat (25), et
un revêtement réfléchissant (26), qui est appliqué sur le substrat (25), **caractérisé en ce que**
le substrat (25) est dopé avec au moins un métal noble (27) dans son volume (V) dans une zone de volume qui s'étend d'une surface du substrat (25) jusqu'à une distance de la surface du substrat (25) de plus de 1 mm.

2. Élément optique réfléchissant selon la revendication 1, dans lequel le substrat (25) est formé de verre, en particulier de verre de quartz dopé au titane, d'une vitrocéramique, d'une céramique, de préférence une céramique de nitrure de silicium, une céramique de carbure de silicium, une céramique de carbonitrure de silicium, une céramique de silicate de magnésium-aluminium, en particulier une céramique de cordiérite, ou d'un matériau composite, en particulier un matériau composite en carbure de silicium infiltré de silicium, SiSiC.

3. Élément optique réfléchissant selon la revendication 1, dans lequel le substrat (25) est formé de silicium, en particulier de silicium monocristallin, quasi-monocristallin ou polycristallin.

4. Élément optique réfléchissant selon l'une quelconque des revendications précédentes, dans lequel la zone de volume dans laquelle le substrat (25) est dopé avec ledit au moins un métal noble (27) s'étend de la surface du substrat (25) jusqu'à une distance de la surface du substrat (25) de plus de 2 mm, en particulier de plus de 5 mm.

5. Élément optique réfléchissant selon l'une quelconque des revendications précédentes, dans lequel le substrat (25) est dopé avec ledit au moins un métal noble (27) dans tout son volume.

6. Élément optique réfléchissant selon l'une quelconque des revendications précédentes, dans lequel le revêtement réfléchissant (26) contient du silicium qui est dopé avec le métal noble (27).

7. Élément optique réfléchissant selon l'une quelconque des revendications précédentes, dans lequel le revêtement réfléchissant forme un revêtement multicouche (26) pour la réflexion du rayonnement EUV (16).

8. Élément optique réfléchissant selon l'une quelconque des revendications précédentes, dans lequel le métal noble (27) est choisi dans le groupe comprenant : Ru, Rh, Pd, Ag, Os, Ir, Pt, Au.

9. Élément optique réfléchissant selon l'une quelconque des revendications précédentes, dans lequel une concentration de dopage du métal noble (27) est comprise entre 10¹⁰ cm⁻³ et 10²⁰ cm⁻³, de préférence entre 10¹² cm⁻³ et 10¹⁶ cm⁻³.

10. Élément optique réfléchissant selon l'une quelconque des revendications précédentes, qui est conçu sous forme de miroir collecteur (17) pour une optique d'éclairage (2) d'une installation de lithographie par projection (1).

11. Ensemble optique, de préférence installation de lithographie par projection (1) pour la microlithographie, en particulier pour la lithographie EUV, comprenant :
au moins un élément optique réfléchissant (17, 19) selon l'une quelconque des revendications précédentes.

12. Procédé de fabrication d'un élément optique réfléchissant (17, 19) selon l'une quelconque des revendications 1 à 10, comprenant:
la fourniture d'un substrat (25),
l'application d'un revêtement réfléchissant (26) sur le substrat (25), **caractérisé en ce que**
le substrat (25) fourni est dopé avec au moins un métal noble (27) dans son volume (V) dans une zone de volume qui s'étend d'une surface du substrat (25) jusqu'à une distance de la surface du substrat (25) de plus de 1 mm.
